# EUROPEAN PATENT APPLICATION

(11) **EP 0 907 307 A1**
(43) Date of publication of application: **07.04.1999**
(21) Application number: 97830492.1
(22) Date of filing: 03.10.1997
(51) Int. Cl.: H05K 1/02, H05K 7/20, H01L 23/367

(54) **Heat sink for surface mount power packages**

(71) Applicant: STMicroelectronics S.r.l., 20041 Agrate Brianza (Milano) (IT)
(72) Inventor: Tiziani, Roberto, 20014 Nerviano (Milano) (IT); Casati, Paolo, 20099 Sesto S. Giovanni (Milano) (IT); Cognetti, Carlo, 20100 Milano (IT); Villa, Claudio Maria, 2058 Villasanta (Milano) (IT)
(74) Representative: Botti, Mario

(57) **Abstract**

The present invention relates to a heat sink for surface mount power packages, of the type comprising a conductive element having at least a surface (9) which is in contact with an exposed surface (6) of slug (5) incorporated into an IC power package (1) to be mounted on a printed circuit board (4). The conductive element (8) of the heat sink is formed by a first portion (8a) passing through a hole (7) provided in said printed circuit board (4) and by a second larger portion (8b) abutting against the printed circuit board (4).

A process is also provide for mounting the heat sink (8) on an IC power package (1) and in contact with an exposed slug (5) surface of the package (1) to be mounted on the printed circuit board (4).

## Description

### Technical Field

The present invention relates to a heat sink for a surface mount power package.

More specifically the invention relates to a heat sink for surface mount power packages, of the type comprising a conductive element having at least a surface which is in contact with an exposed surface of slug incorporated into an IC power package to be mounted on a printed circuit board.

The invention also relates to a process for mounting said heat sink on a printed circuit board and in contact to an exposed slug surface of the power package.

More particularly, but not exclusively, the invention relates also to a high power IC surface mount package including an external heat sink fixed to an exposed surface of a slug incorporated into the package.

### Background art

As is well known in this specific technical field, the increasing demand of miniaturisation and quality in power applications has pushed the market of IC to develop new technologies in the manufacturing of power systems.

Automotive, industrial audio and telecom markets are now taking advantage of the use of Surface Mount Technology (SMT) in the manufacturing of IC power packages for printed circuit boards.

The major advantages offered by SMT are size reduction, automated board mounting, high reliability and cost effectiveness. Moreover, a larger density of functions is achieved in smaller systems.

The evolution of SMT in the last twelve years has offered a continued development of new packages which are manufactured through totally automated mounting lines.

Only a few devices are not yet compatible with the SMT principles; among them: large capacitors and resistors and many power semiconductor packages.

The existing power packages present several drawbacks:
- they have a traditional insertion structure and are mounted manually on printed circuit boards, with a loss of time and productivity;
- they force the use of wave soldering techniques and are not compatible with reflow techniques;
- they are not answering to the increasing demand of miniaturised power systems.

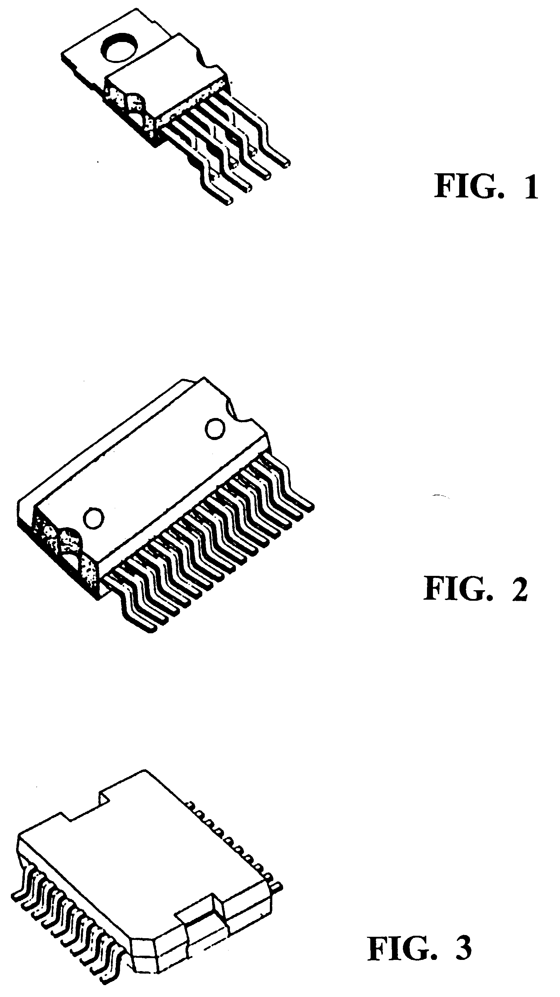

A first prior art solution to remedy to the above listed drawbacks was introduced on the market in 1989 by the applicant and by a surface mount package shown in Figure 1. This package includes seven leads which are extended at one side of the package and present shaped ends to facilitate bonding on the printed circuit board.

A second prior art solution is shown in Figure 2 and relates to a surface mount package known with the trade name of "Multiwatt".

Those solutions are not totally satisfactory for a number of reasons:
- the handling of the package is complicated by its asymmetrical structure;
- the size is not answering to the current miniaturisation demand;
- the coplanarity of the leads is not satisfactory because of the leads length;
- the limited pins number is no longer able to meet the current requirements for advanced smart power packages.

Those drawbacks have been solved by a new and original SMT package designed by the applicant in 1994 to cover from 20 to 36 leads for smart power products and including an internal massive slug which provides the same thermal impedance as traditional insertion packages.

The slug is incorporated into the package but with an exposed surface so that it may be soldered onto the printed circuit board during the surface mount process. The exposed surface may be up or down according to the slug position inside the package.

For high power applications, up to 20 Watt, in order to get a thermal performance (Rth) of few °C/W, a large and massive external heatsink is required in close contact with the power device.

Figure 4 shows a schematic vertical cross section a "slug down" power package which is mounted on an epoxy board having a through cavity corresponding to the package slug. An external heatsink is directly applied in contact with the slug and secured by means of a spring system or glued. A high level of dissipation can be achieved with properly designed heatsinks.

However, because of the printed circuit board thickness tolerances and because of the package stand-off tolerances, a possible stress on the package bonded leads is present when pressure is applied on the package, as shown in figure 4A.

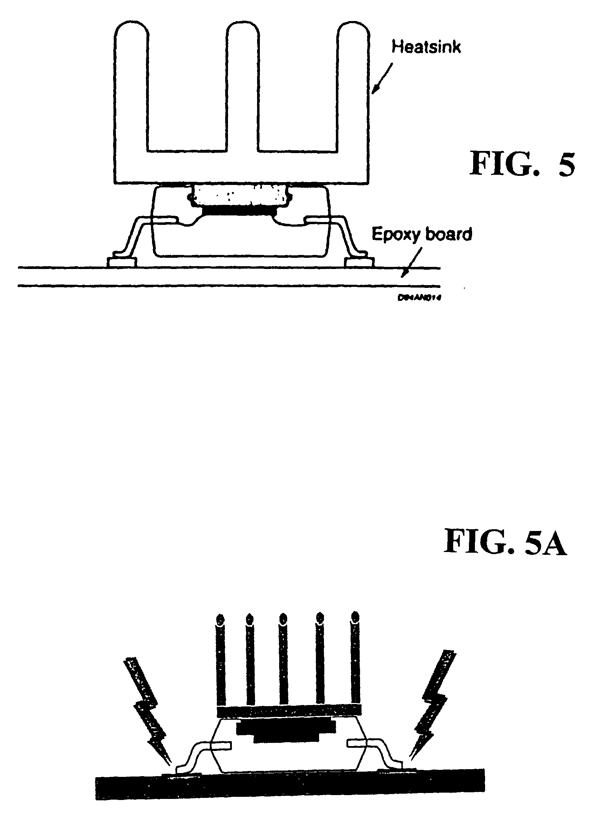

Figure 5 shows a power package with a reverse or "slug-up" configuration with a clip mounted external heatsink. This solution is disclosed in the U.S. patent No. and allows a 5-6 W dissipation in forced ventilation.

This solution presents a disadvantage due to the high stress on the package leads during a vibration test, as shown in figure 5A.

The technical problem underlining the present invention is that of providing a heat sink for surface mount power packages and a corresponding mounting method having structural and functional features to allow high power dissipation with package lead stress free.

### Summary of the invention

The solution idea on which the invention is based is that of providing a metal button interposed in the printed circuit board and to solder the package slug to such a metal button by a reflow thermal process step.

According to this solution idea, the technical problem is solved by a heat sink for surface mount power packages as defined by the enclosed claim 1.

The technical problem is solved also by a heat sink mounting process defined by the enclosed claims 10 and following.

The feature and advantages of heat sink and the corresponding mounting method will appear from the following non-limiting description of a preferred embodiment given by way of example with reference to the annexed drawings.

### Brief description of the drawings

- Figures 1 and 2 show perspective views of surface mount power packages according to the prior art;
- Figure 3 is a perspective view of a known power package having a small outline and a high dissipation capability;
- Figure 4 shows a schematic vertical cross section of a "slug-down" power package of Figure 3 connected to an external heatsink;
- Figure 4A shows a schematic vertical cross section of the "slug-down" power package of Figure 4 under pressure conditions;
- Figure 5 shows a schematic vertical cross section of a power package with a reverse or "slug-up" configuration and with a clip mounted external heatsink;
- Figure 5A shows a schematic vertical cross section of the "slug-up" power package of Figure 5 during a vibration test;
- Figure 6 shows a schematic vertical cross section of the "slug-up" power package including an external heat sink according to the present invention;
- Figure 7 shows a top plan view of a portion of a printed circuit board prepared according to the inventive method to embrace a heat sink according to the invention;
- Figure 8 shows a top plan view of the back side of the Figure 7 printed circuit board portion;
- Figure 9 shows a top plan view of a supply tape of heat sinks;
- Figure 10 shows a top plan view of the back side of the printed circuit board portion during one step of the inventive process;
- Figures 11 and 12 show respective schematic vertical cross sections external heat sink according to the present invention mounted on the printed circuit board;
- Figure 13 a schematic vertical cross section of the "slug-up" power package including the external heat sink of Figure 12 at the end of the inventive process.

### Detailed description

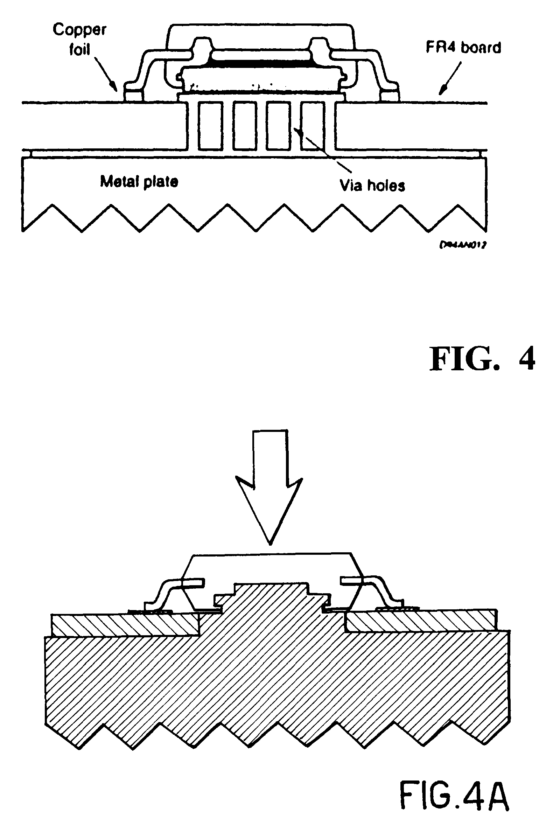

With reference to the above figures, and more specifically to the example of figure 3, with 1 is globally indicated a "slug-down" power package including an electronic semiconductor integrated circuit 2.

The circuit 2 comprises circuit pads (not shown) which are electrically connected by lead wires to corresponding lead pins 3. The pins 3 allow to mount and to connect the package 1 on a printed circuit board 4.

The circuit 2 is mounted on a slug 5 which presents an exposed surface 6 toward the printed circuit board 4. For this reason the package is defined as a "slug-down" package meaning that the slug exposed surface abuts the printed circuit board main surface 10.

However, according to the present invention, the printed circuit board is provided with a hole 7 corresponding to the slug position.

The hole 7 is slightly wider than the size of the slug 5.

The hole 7 is provided to receive a conductive element and more specifically a metal button 8 which is an external heat sink. Such a metal button 8 will cooperate with the slug 5 to dissipate the heat produced by the integrated circuit 2.

The metal button 8 comprises a first portion 8a, which corresponds to the size of the hole 7, and a larger second portion 8b. The two portions 8a and 8b may be formed integrally and the metal button is preferably formed by copper.

The first portion 8a has a thickness corresponding to the thickness of the printed circuit board 4.

The metal button 8 is inserted in the hole 7 so that the top surface 9 of the first portion 8a abuts against the slug 5 of the package 1, while the second portion 8b abuts against the back surface 11 of printed circuit board 4 with respect to the position of the package.

The top surface 9 of the metal button 8 is provided with a special soldering plating, for instance an alloy of a Pb/Sn plating, which will be useful to fix together the slug 5 and the metal button 8.

Moreover, glue drops are provided on the back surface 11 of the printed circuit board 4 and around the edges of the hole 7 to fix and hold the second portion 8b of the metal button 8.

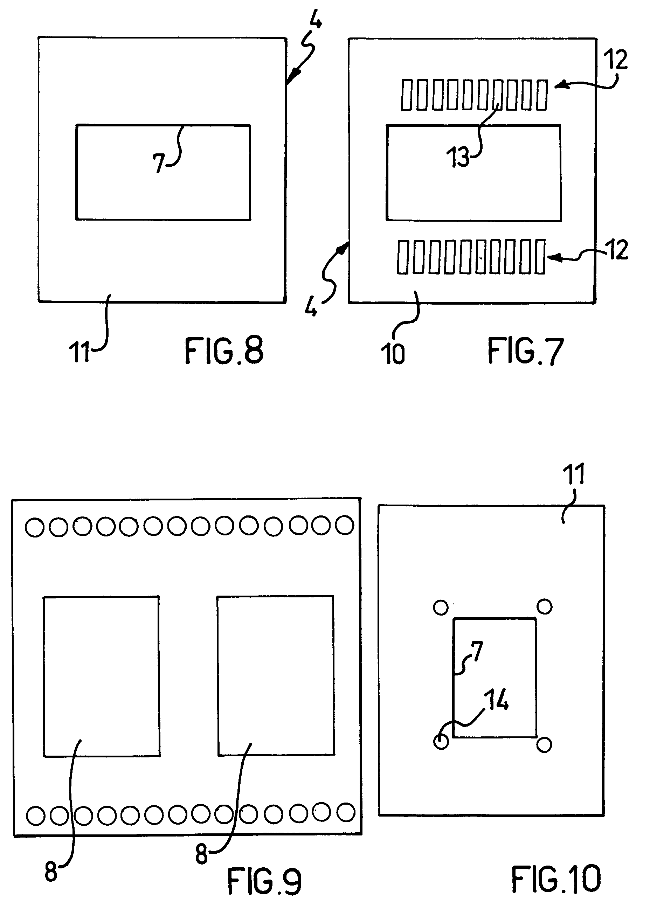

More specifically, the above handling and positioning operations are performed by an automatic pick and place machine which acts on the printed circuit board 4 as shown schematically in Figures 7 and following.

First of all the printed board 4 is prepared with the hole 7 corresponding to the slug 5 incorporated into the package 1. The hole 7 is realised between opposite series 12 of board pads 13 which are provided on the printed circuit board 4 for bonding the lead pins 3 of the package 1.

A conventional pick and place machine handle the printed board 4 and reverse the board to place it upside down, so that the back surface 11 of the board 4 remains exposed, as shown in Figure 8.

A set of metal buttons 8 are supplied to the pick and place machine in tape and reel form, as shown in Figure 9. The metal buttons 8 will be used as heat sinks for some power packages to be mounted on the printed circuit board 4.

The inventive process proceeds with a further step providing glue drops 14 on the back surface 11 of the printed board 4 close to the hole 7.

The drops are positioned by the pick and place machine close to the corners of the hole 7, as shown in Figure 10.

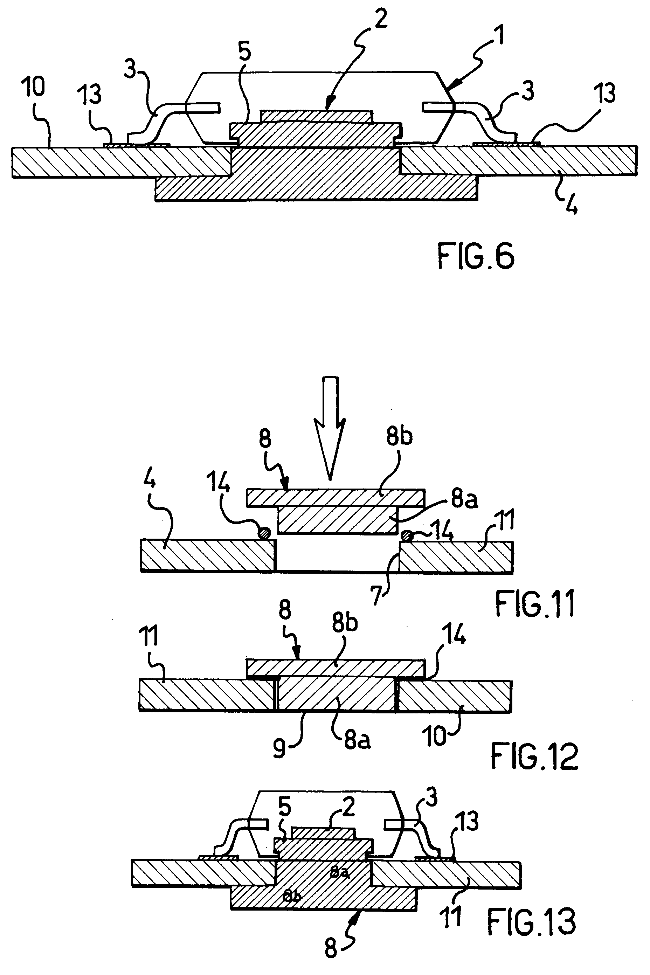

The metal button 8 is placed on the printed circuit board 4 as shown in Figure 11. The first button portion 8a is inserted into the hole 7 so that the second button portion 8b abuts against the back surface 11 of the board 4 around the hole 7.

A glue curing phase is provided to solder the metal button 8 as shown in Figure 12.

The board 4 is now provided with an external heat sink which will cooperate with the slug 5 incorporated into the package 1 to dissipate the heat produced by the integrated circuit.

The pick and place machine flips and reverse the position of the printed circuit board so that the package 1 may be mounted on the board 4 with the lead pins 3 corresponding in number and position to the sets 12 of board pads 13.

Conventional placement and reflow process steps are performed to complete the mounting of the package 1.

## Claims

1. Heat sink for surface mount power packages, of the type comprising a conductive element having at least a surface (9) which is in contact with an exposed surface (6) of slug (5) incorporated into an IC power package (1) to be mounted on a printed circuit board (4), characterised in that said conductive element (8) is formed by a first portion (8a), including said surface (9), passing through a hole (7) provided in said printed circuit board (4) and by a second larger portion (8b) abutting against the printed circuit board (4).

2. Heat sink according to claim 1, characterised in that said conductive element (8) is a metal button.

3. Heat sink according to claim 2, characterised in that said metal button (8) is made by copper.

4. Heat sink according to claim 1, characterised in that said hole (7) is slightly wider than the size of the slug (5).

5. Heat sink according to claim 1, characterised in that said first portion (8a) has a thickness corresponding to the thickness of the printed circuit board (4).

6. Heat sink according to claim 2, characterised in that said metal button (8) is inserted in the hole (7) so that the top surface (9) of the first portion (8a) abuts against the slug (5) of the package (1) while the second portion (8b) abuts against the back surface (11) of printed circuit board (4).

7. Heat sink according to claim 2, characterised in that the top surface (9) of the metal button (8) is provided with a special plating.

8. Heat sink according to claim 7, characterised in that said plating is made by an alloy Pb/Sn.

9. Heat sink according to claim 1, characterised in that

10. A process for mounting a heat sink (8) on an IC power package (1) and in contact with an exposed slug (5) surface of the package (1) to be mounted on a printed circuit board (4), comprising the following steps:
- providing a hole (7) in the printed circuit board (4);
- providing a heat sink (8) with a first portion (8a) passing through said hole (7) and a second larger portion (8b) abutting against a surface (11) of said board (4);
- mounting said package (1) on said board (4) putting in contact and fixing the exposed slug (5) surface with a surface (9) of said heat sink (8).

11. A process according to claim 10, characterised in that glue is provided close and/or around the hole (7) on the abutting surface (11) of the board (4).

12. A process according to claim 10, characterised in that said hole (7) is slightly wider than the size of the slug (5).

13. A process according to claim 10, characterised in that said heat sink (8) is formed by a metal button comprising said first portion (8a) passing through the hole (7) provided in said printed circuit board (4) and a second larger portion (8b) abutting against the back surface (11) of printed circuit board (4).

14. A process according to claim 10, characterised in that said first portion (8a) has a thickness corresponding to the thickness of the printed circuit board (4).

15. A process according to claim 13, characterised in that the top surface (9) of the metal button (8) is provided with a soldering plating.

16. A high power IC surface mount package including an external heat sink according to claim 1.
